# EUROPEAN PATENT APPLICATION

(11) **EP 2 306 490 A1**
(43) Date of publication of application: **06.04.2011**
(21) Application number: 09179041.0
(22) Date of filing: 14.12.2009
(51) Int. Cl.: H01J 37/34, C23C 14/35

(54) **Magnet arrangement for a target backing tube and target backing tube comprising the same**

(30) Priority: 02.10.2009 EP 09172144
(71) Applicant: Applied Materials, Inc., Santa Clara, CA 95054 (US)
(72) Inventor: Hellmich, Anke, 63796, Kahl (DE); Krock, Wolfgang, 63526, Erlensee (DE)
(74) Representative: Zimmermann & Partner

(57) **Abstract**

The disclosure concerns a magnet arrangement (124a, 124b, 200) for a target backing tube (122a, 122b) for a rotatable target of a sputtering system (100), the magnet arrangement having a longitudinal axis and a circumferential direction around the longitudinal axis (X), and being adapted for an arrangement in a cylindrical backing tube, wherein the magnet arrangement comprises in a circumferential sequence: a first magnet element (210) extending in parallel to the longitudinal axis, a second magnet element (220) extending in parallel to the longitudinal axis, and a third magnet element (230) extending in parallel to the longitudinal axis, wherein each magnet element has a center axis extending in a radial direction, wherein the angular distance between the first and the third magnet elements, with respect to their center axis, is less than about 85 degrees. Further, the disclosure concerns a target backing tube (122a, 122b) for a rotatable target of a sputtering system, wherein the target backing tube has a longitudinal axis, wherein the target backing tube contains a magnet arrangement (124a, 124b, 200) according to one embodiment disclosed herein, wherein the longitudinal axis of the magnet arrangement corresponds to the longitudinal axis of the backing tube. Further, the disclosure concerns a cylindrical target assembly (120a, 120b) comprising a target backing tube (122a, 122b) according to one embodiment disclosed herein, and at least one target cylinder disposed around the target backing tube. Finally, the disclosure concerns a sputtering system (100) comprising a vacuum chamber (110) and at least one target backing tube according to one embodiment disclosed herein, wherein the target backing tube is disposed in the vacuum chamber.

## Description

The present disclosure relates to a magnet arrangement for a target backing tube. More specifically the present disclosure relates to a magnet arrangement for a target backing tube for a rotatable target of a sputtering system. Further, the present disclosure relates to a target backing tube for a rotatable target of a sputtering system. Additionally, the present disclosure relates to a cylindrical target assembly comprising a target backing tube. Further, the present disclosure relates to a sputtering system comprising a vacuum chamber and at least one target backing tube.

### BACKGROUND

In many applications, it is necessary to deposit thin layers on a substrate. The term "substrate" as used herein shall embrace both inflexible substrates, e.g. a wafer or a glass plate, and flexible substrates, for example webs and foils. Typical techniques for depositing layers are evaporating, sputtering and chemical vapor deposition.

Representative examples include (but are not limited to) applications involving: semiconductor and dielectric materials and devices, silicon-based wafers, flat panel displays, masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

In an evaporation process, the material to be deposited is heated so that it evaporates and condenses on the substrate. Sputtering is a vacuum coating process used to deposit thin films of various materials onto the surface of a substrate. For example, sputtering can be used to deposit a metal layer, such as a thin layer of aluminum, or ceramics. During the sputtering process, the coating material is transported from a target to the substrate to be coated by bombarding the surface of the target with ions of an inert gas which have been accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of the substrate's exposure to the sputtering process.

Typically, sputtering systems are used to coat substrates, for example window paints, semiconductor devices, displays, and the like. Typically plasma is formed in a vacuum chamber, in which the sputtering target is disposed. For example, rotating sputtering targets may be used. Typically, the rotating sputtering targets have a cylindrical form and rotate about their longitudinal axis. The sputtering targets are disposed on a backing tube in which magnetrons may be arranged. The magnetrons may be driven by a direct current or an alternating current. The magnetrons are used to create the plasma in the vacuum chamber. The magnetrons in the target backing tube are typically cooled.

Typically, a magnet arrangement or rotary cathode is disposed in the backing tube. The magnet arrangement or rotary cathode has a plurality of magnets disposed along its circumference. World-wide a lot of different rotary cathodes are used from different suppliers with different magnetic field arrangements.

### SUMMARY

In light of the above, a magnet arrangement for a target backing tube according to independent claim 1, a target backing tube for a rotatable target according to claim 5, a cylindrical target assembly according to claim 7, and a sputtering system according to independent claim 9 are provided.

According to one aspect, a magnet arrangement for a target backing tube for a rotatable target of a sputtering system is provided, the magnet arrangement having a longitudinal axis and a circumferential direction around the longitudinal axis, and being adapted for an arrangement in a cylindrical backing tube, wherein the magnet arrangement includes in a circumferential sequence: a first magnet element extending in parallel to the longitudinal axis, a second magnet element extending in parallel to the longitudinal axis, and a third magnet element extending in parallel to the longitudinal axis, wherein each magnet element has a center axis extending in a radial direction, wherein the angular distance between the first and the third magnet elements, with respect to their center axis, is less than about 85 degrees.

In an embodiment, the angular distance between at least one pair of adjacent magnet elements, with respect to their center axis, is between 20 and 45 degrees, in particular between 20 and 40 degrees.

According to a further embodiment, which may be combined with other embodiments disclosed herein, the angular distance between at least one pair of adjacent magnet elements is smaller than about 35 degrees, in particular greater than 25 degrees, for example about 28 degrees.

In a typical embodiment, each magnet element has a radial free end, wherein the radial free end is disposed in a distance of about 40 to 80mm, in particular 50 to 60mm, from the longitudinal axis.

According to a further aspect, a target backing tube for a rotatable target of a sputtering system is provided, wherein the target backing tube has a longitudinal axis, wherein the target backing tube contains a magnet arrangement according to one embodiment disclosed herein, wherein the longitudinal axis of the magnet arrangement corresponds to the longitudinal axis of the backing tube.

In a typical embodiment, the longitudinal extension of the target backing tube in a vacuum chamber into which the target backing tube is adapted to be disposed corresponds substantially to the longitudinal extension of the first, second and third magnet element.

According to another aspect, a cylindrical target assembly is provided comprising a target backing tube according to one embodiment disclosed herein, and at least one target cylinder disposed around the target backing tube.

In a typical embodiment, the at least one target cylinder is selected form a group consisting of an ITO, an AZO, an IGZO or a GZO target cylinder.

According to a further aspect, a sputtering system comprising a vacuum chamber and at least one target backing tube according to embodiments disclosed herein is provided, wherein the target backing tube is disposed in the vacuum chamber.

In a typical embodiment, the sputtering system includes a substrate support for a substrate to be coated, wherein the substrate support is disposed in the vacuum chamber and has a support surface facing the at least one target cylinder.

In a typical embodiment, the sputtering system includes a substrate support device for a substrate to be coated, wherein the substrate support device is disposed in the vacuum chamber, such that the normal of a surface to be coated of a substrate is corresponds substantially to the center axis of the second magnet element.

In an embodiment, which may be combined with other embodiments disclosed herein, the magnet arrangement is arranged, such that the second magnet element is facing the substrate support, in particular the center axis of the second magnet element corresponds substantially to the normal of the support surface.

In a typical embodiment, the sputtering system includes two target backing tubes according to an embodiment disclosed herein, wherein the longitudinal axis of the two target backing tubes are substantially parallel to each other.

In a further embodiment, the magnet arrangements are arranged symmetrically to each other, in particular with respect to a plane between the two target backing tubes normal to the support surface.

Further aspects, advantages and features of the present invention are apparent from the dependent claims, the description and the accompanying drawings.

### BRIEF DESCRIPTION OF THE DRAWINGS

A full and enabling disclosure including the best mode thereof, to one of ordinary skill in the art, is set forth more particularly in the remainder of the specification, including reference to the accompanying figures wherein:
Fig. 1 shows a schematical cross-sectional view of an embodiment of a sputtering system;
Fig. 2 shows a schematical cross-sectional view of an embodiment of a magnet arrangement; and
Fig. 3 shows a schematical side view of the embodiment of a magnet arrangement of Fig. 2.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

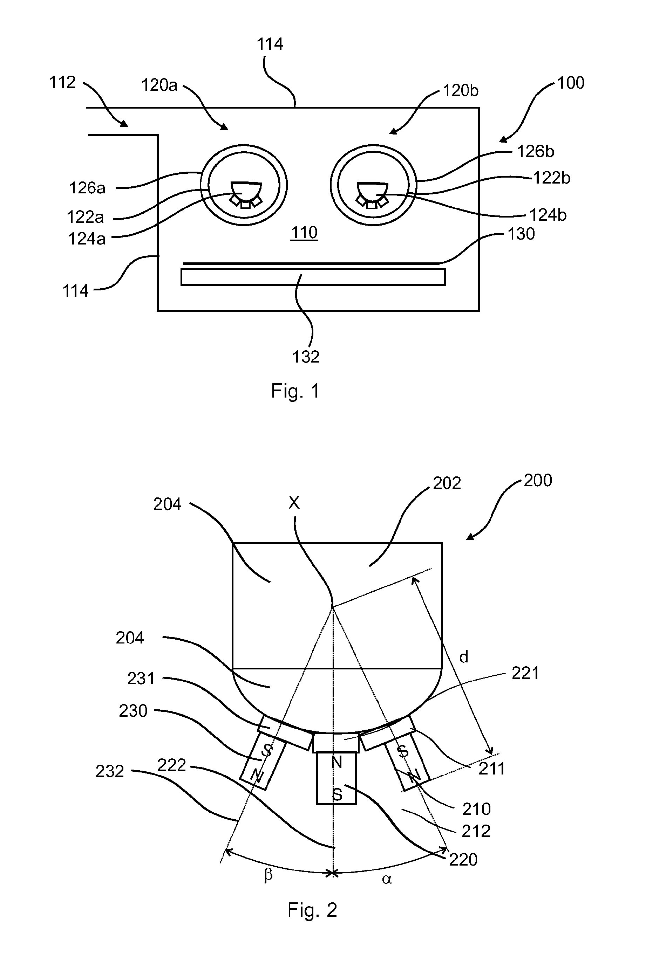

Referring to the drawings, where like or similar elements are designated with identical reference numbers throughout the different figures, Fig. 1 shows a schematic cross-section of a sputtering system 100 having a vacuum chamber 110. The vacuum chamber has an inlet port 112, which may be used to provide a sputtering gas into the vacuum chamber 110, and may include an outlet (pumping) port (not shown). The vacuum chamber is limited by vacuum chamber walls 114. In typical embodiment, the sputtering system 100 includes two rotating cylindrical target assemblies 120a, 120b. In other embodiments, which may be combined with other embodiments disclosed herein, the sputtering system may include one, three, four or more cylindrical target assemblies. In a typical embodiment, which may be combined with other embodiments disclosed herein, the rotating cylindrical target assemblies 120a, 120b are driven by a drive assembly not shown in Fig. 1. The rotating cylindrical target assemblies 120a, 120b each include a backing tube 122a, 122b in which magnet arrangements 124a, 124b are disposed. Further, cylindrical target elements 126a, 126b are disposed around the backing tube 122a, 122b. For example, the cylindrical target elements 126a, 126b may be not bonded to the respective backing tube 122a, 122b. For example, the cylindrical target elements 126a, 126b may be exchanged after they have been used up. In a typical embodiment, the indium tin oxide (ITO) targets may be used as target elements. In another embodiment, target elements of a ceramic material may be used. In Fig. 1 horizontal rotating cylindrical target assemblies are shown. In some embodiments, which may be combined with other embodiments disclosed herein, vertical cylindrical target assemblies may be used.

Further, in the vacuum chamber 110, a substrate 130 is disposed below the cylindrical target assemblies 120a, 120b. The substrate 130 may be arranged, in a typical embodiment, which may be combined with other embodiments disclosed herein, on a substrate support 132. In a typical embodiment, which may be combined with other embodiments disclosed herein, a substrate support device for a substrate to be coated is disposed in the vacuum chamber. For example, the substrate support device may include conveying rolls, magnet guiding systems, and further features.

In operation a plasma is formed inside the vacuum chamber 110 between the cylindrical target assembly and the anode by exciting a sputtering gas. In a typical embodiment, the sputtering gas includes argon. In further embodiments, the vacuum chamber may include substrate drive systems for driving a substrate to be coated 130 in or out of the vacuum chamber 110. For that reason, the vacuum chamber may include a vacuum lock chamber disposed at a wall of the vacuum chamber 110. In an embodiment, which may be combined with other embodiments disclosed herein, the rotating axis of the cylindrical target assemblies 120a, 120b are substantially parallel.

Typically, the magnets or the magnet elements 124a, 124b have an elongated structure extending in parallel to the longitudinal extension of the backing tube 122a, 122b, in which they are disposed, for example parallel to the longitudinal or rotating axis of the backing tubes 122a, 122b. Typically, the magnet elements 124a, 124b have substantially the same length as the backing tubes. For example the magnet arrangement may have a length of about 80% or more, for example 90% or more, of the longitudinal extension of a portion of the backing tube in the vacuum chamber 110. In a typical embodiment, the magnet elements of the magnet arrangement are disposed that north and south pole are alternating in circumferential direction. Typically the magnet elements may include one or more, in particular a plurality, of single magnets. Then, these magnets of a magnet element are placed along the longitudinal axis of the magnet arrangement one after another.

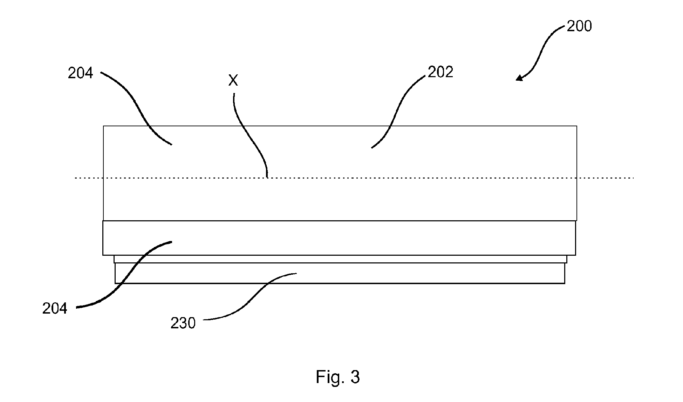

Fig. 2 shows a cross section of an embodiment of a magnet arrangement 200 for a target backing tube. Fig. 3 shows the respective schematical side view of the magnet arrangement 200. The magnet arrangement 200 has a longitudinal axis X which is substantially orthogonal to the paper plane. Typically, when mounted in the backing tube 122a, 122b, the longitudinal axis corresponds or is in parallel to the rotating axis of the backing tube 122a, 122b. The magnet arrangement 200 may include in one embodiment, which may be combined with other embodiments disclosed herein, a basic body 202 having a substantially rectangular portion in the cross section 204 and a semi-oval portion 206 in cross-section disposed on the rectangular portion 204. The rectangular portion 204 and the semi-oval portion 206 may be produced in one piece. In another embodiment, the basic body 202 may only include a semi-oval or a semi-circular portion 206. Typically, the semi-oval portion 206 has a round surface 208 and a flat surface which is disposed on the rectangular portion 204 of the basic body 202. In an embodiment, the basic body 202 is arranged in the backing tube of a vacuum chamber, such that the round surface 208 of the semi-oval portion 206 is adapted to face the substrate to be coated 130.

In an embodiment, which may be combined with other embodiments herein, a first magnet element 210, a second magnet element 220 and a third magnet element 230 are disposed on the round surface 208, each magnet element is extending in parallel to the longitudinal axis X of the magnet arrangement. The poles adapted to face the substrate 130 are arranged alternatingly. For example, in an embodiment, a south pole may be arranged between two north poles. In another embodiment, a north pole may be arranged between two south poles, each adapted to face the substrate 130. In a typical embodiment, an intermediate support member 211, 221, 231 is disposed between the magnet elements and the basic body 202. Each magnet has a center axis 212, 222, 232 extending in a radial direction from the longitudinal axis X. In other embodiments, which may be combined with other embodiments disclosed herein, the intermediate support members 211, 221, 231 may be adapted such that the center axis 212, 222, 232 of each magnet element 210, 220, 230 extend in radial direction, for example even in case of a rectangular basic body. In the embodiment shown in Fig. 2, a first angular distance α between the center axis 212 of the first magnet element 210 and the center axis 222 of the second magnet element 220 is about 18° to 35°, for example about 25 to 30°. In a further embodiment, the angular distance α is about 35° to 50°, for example, in an embodiment 40° to 45°. Further, a second angular distance β between the center axis 222 of the second magnet element 220 and the center axis 232 of the third magnet element 230 is in a typical embodiment, which may be combined with other embodiments disclosed herein, substantially equal to the first angular distance α. In a typical embodiment, which may be combined with other embodiments disclosed herein, the angular distance between the center axis 212 of the first magnet element 210 and the center axis 232 of the third magnet element 230 is less than about 85°, for example in an embodiment less than 60°. In another embodiment, which may be combined with other embodiments disclosed herein, the first and/or the second angular distance may be between about 20° and about 40°, in particular between about 25° and about 30°, for example about 28°. Typically, the distance d between the longitudinal axis X and the three radial ends of the magnet elements 210, 220, 230 is between 50 and 60 mm. In further embodiments, the distance d may be about 56 mm.

Typically, the magnetic angle of the magnet fields has a high importance for the sputtering process. Typically, in the case of an embodiment with an indium tin oxide (ITO) target element, an angle between the center axes of the first and the second magnetic element 210, 220 and/or the second and third magnetic element 220, 230 is between 20° and 45°. In particular the angle between the center axes of two adjacent magnetic elements 210, 220, 230 may be about 28°. In some embodiments, lower angles may lead to plasma and/or process instabilities and very high angles may lead to lower deposition rates. Further, in some embodiments, higher angles between the center axes of adjacent magnets may lead to different film properties dependent on the position of the substrate to be coated to the cathode, for example the cylindrical target assemblies.

Typically, in some embodiments, higher angles may lead to that a static deposition is not possible because of huge differences in film properties on the substrate and typical film properties for dynamic deposition may be worse because of averaging. In a dynamic deposition, the substrate is moved with respect to the targets and/or the vacuum chamber, for example by a conveying device.

In some embodiments, the appropriate angle for the magnetic fields, in particular the magnetic elements 210, 220, 230, may be important for using of rotary cathodes or cylindrical target assemblies in static depositions especially for ceramic materials. In a static deposition the substrate to be coated is substantially not moved with respect to the targets and/or the vacuum chamber.

Typically, with the magnetic arrangement according to the embodiments disclosed herein the deposition rate is improved. In particular less scattering and shielding coating is performed during the sputtering process. During shielded coating, a shield is disposed in the vacuum chamber to shield the walls of the vacuum chambers against the deposition of material. Thus, the material is deposited on the shields which may be easily removed from the vacuum chamber and cleaned.

Typically, in dynamic deposition the film properties of the coated material, for example a ceramic layer or and ITO layer, are improved in dynamic deposition. Further, in a static deposition of ITO a film with expected film properties is possible. Typically, in some embodiments, the process conditions of the sputtering process are more stable.

Fig. 3 shows a further schematic cross section of a portion of a vacuum chamber comprising a substrate to be coated 310, a first cylindrical target assembly 320a and a second cylindrical target assembly 320b. In a typical embodiment, the substrate to be coated may be arranged substantially horizontal. In other embodiments, the substrate to be coated may be vertical. A first magnet arrangement 340a is disposed in the first cylindrical target assembly 320a, and a magnet arrangement 340b is disposed in the first cylindrical target assembly 320b. Typically, the first and the second cylindrical target assembly 320a, 320b are disposed parallel to each other, in particular parallel to the substrate 310 to be coated.

The first and the second magnet arrangement 340a, 340b have respectively three magnet elements, a first magnet element 342a, 342b, a second magnet element 344a, 344b and a third magnet element 346a, 346b. The second magnet element 344a, 344b is respectively arranged between the first magnet elements 342a, 342b and the third magnetic elements 346a, 346b. The magnet arrangements 340a, 340b may correspond in some embodiments to the magnet arrangement shown in Figs 2 and 3.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allow for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims

## Claims

1. A magnet arrangement (124a, 124b, 200) for a target backing tube (122a, 122b) for a rotatable target of a sputtering system (100), the magnet arrangement having a longitudinal axis and a circumferential direction around the longitudinal axis (X), and being adapted for an arrangement in a cylindrical backing tube, wherein the magnet arrangement comprises in a circumferential sequence:
a first magnet element (210) extending in parallel to the longitudinal axis,
a second magnet element (220) extending in parallel to the longitudinal axis, and
a third magnet element (230) extending in parallel to the longitudinal axis, wherein
each magnet element has a center axis extending in a radial direction, wherein
the angular distance between the first and the third magnet elements, with respect to their center axis, is less than about 85 degrees.

2. The magnet arrangement according to claim 1, wherein
the angular distance between at least one pair of adjacent magnet elements (210, 220, 230), with respect to their center axis, is between 20 and 45 degrees, in particular between 20 and 40 degrees.

3. The magnet arrangement according to claim 1 or 2, wherein
the angular distance between at least one pair of adjacent magnet elements is smaller than about 35 degrees, in particular greater than about 25 degrees, for example about 28 degrees.

4. The magnet arrangement according to one of the preceding claims, wherein
each magnet element has a radial free end, wherein the radial free end is disposed in a distance of about 40 to 80mm, in particular 50 to 60mm, from the longitudinal axis.

5. A target backing tube (122a, 122b) for a rotatable target of a sputtering system,
wherein
the target backing tube has a longitudinal axis, wherein the target backing tube contains a magnet arrangement (124a, 124b, 200) according to one of the preceding claims, wherein the longitudinal axis of the magnet arrangement corresponds to the longitudinal axis of the backing tube.

6. The target backing tube according to claim 5, wherein
the longitudinal extension of the target backing tube (122a, 122b) in a vacuum chamber (110) into which the target backing tube is adapted to be disposed corresponds substantially to the longitudinal extension of the first, second and third magnet element.

7. A cylindrical target assembly (120a, 120b) comprising
a target backing tube (122a, 122b) according to one of the claims 5 to 6, and
at least one target cylinder disposed around the target backing tube.

8. The cylindrical target assembly according to claim 7, wherein
the at least one target cylinder is selected form a group consisting of an ITO, an AZO, an IGZO, and a GZO target cylinder.

9. A sputtering system (100) comprising
a vacuum chamber (110) and at least one target backing tube according to one of the claims 7 and 8, wherein the target backing tube is disposed in the vacuum chamber.

10. The sputtering system according to claim 9, further comprising at least one target cylinder disposed around the target backing tube.

11. The sputtering system according to claim 10, wherein
the at least one target cylinder is selected form a group consisting of an ITO, an AZO, an IGZO, and a GZO target cylinder.

12. The sputtering system according to one of the claims 9 to 11, further comprising a substrate support (132) for a substrate to be coated, wherein the substrate support is disposed in the vacuum chamber and has a support surface facing the at least one target cylinder.

13. The sputtering system according to claim 12, comprising
a substrate support device (132) for a substrate to be coated, wherein the substrate support device is disposed in the vacuum chamber, such that the normal of a surface to be coated of a substrate is corresponds substantially to the center axis of the second magnet element.

14. The sputtering system according to one of the claims 9 to 13, comprising two target backing tubes according to one of the claims 6 and 7, wherein the longitudinal axis of the two target backing tubes are substantially parallel to each other.

15. The sputtering system according to claim 14, wherein
the magnet arrangements are arranged symmetrically to each other, in particular with respect to a plane between the two target backing tubes normal to the support surface.
